# EUROPEAN PATENT APPLICATION

(11) **EP 0 548 862 A1**
(43) Date of publication of application: **30.06.1993**
(21) Application number: 92121660.2
(22) Date of filing: 19.12.1992
(51) Int. Cl.: H03H 9/02

(54) **Surface accoustic wave device**

(30) Priority: 27.12.1991 JP 346028/91; 23.03.1992 JP 64511/92; 23.03.1992 JP 64512/92; 23.03.1992 JP 64513/92; 23.03.1992 JP 64522/92; 23.03.1992 JP 64523/92
(71) Applicant: MATSUSHITA ELECTRIC INDUSTRIAL CO., LTD., Kadoma-shi, Osaka-fu, 571 (JP)
(72) Inventor: Taguchi, Yutaka, Settsu-shi, Osaka-fu (JP); Eda, Kazuo, Nara-shi, Nara-ken (JP); Oonishi, Keiji, Settsu-shi, Osaka-fu (JP); Seki, Shunichi, Osaka-shi, Osaka-fu (JP)
(74) Representative: Eisenführ, Speiser & Partner

(57) **Abstract**

A surface acoustic wave device in which at least one of a surface acoustic wave transducer and reflectors is made of an aluminum metal containing 0.01 to 0.5 % by weight of scandium, which device can suppress electromigration and stress-induced migration and prevent degradation of electrodes.

## Description

### BACKGROUND OF THE INVENTION

### Field of the Invention

The present invention relates to a surface acoustic wave device such as a surface acoustic wave resonator and a surface acoustic wave filter, and in particular, a surface acoustic wave device which operates at high frequencies and high electric powers.

### Description of the Related Art

Recently, surface acoustic wave devices have been extensively studied so as to use them as resonators or filters. With the progress of mobile communication systems and use of the surface acoustic wave device in a high frequency rage, it is necessary for a surface acoustic wave device to be fitted to the high frequency wave.

As is well known, a basic structure of the surface acoustic wave resonator comprises a piezoelectric substrate, comb-form electrodes for generating a surface acoustic wave (interdigital transducer) which are formed on a surface of the substrate, and grating reflectors which are provided on both sides of the electrodes and each of which comprises plural metal strips each having a width of λ/4 periodically arranged at a pitch of λ/2. The surface acoustic wave which is generated by the interdigital transducer propagates the surface of the piezoelectric substrate and is reflected by the reflectors back to the interdigital transducer. While a reflected amount per one strip is small, the surface acoustic wave is reflected by a number of strips at a distance of a half of the wavelength, so that the reflected surface acoustic waves are accumulated and a ratio of the reflected amount of the waves reaches about one. Under such circumstance, a strong standing wave of the surface acoustic wave is formed on the piezoelectric substrate. This phenomenon corresponds to a resonance phenomenon of a quartz resonator. By the suitable adjustment of positions and the number of the reflectors, the resonator having the same function as the quartz resonator can be set up.

As is well known, a basic structure of the surface acoustic wave filter comprises a piezoelectric substrate, at least one pair of surface acoustic wave transducers for generating the surface acoustic wave which are formed on the piezoelectric substrate, wherein one of the surface acoustic wave transducers is used as an input terminal and the other as an output terminal and a frequency characteristics of an electric signal-surface acoustic wave-electric signal conversion is utilized to function the device as a filter.

Hitherto, aluminum is used as a usual electrode material of the surface acoustic wave device, since it is advantageous over other metals in view of its good processability, low density and light weight.

When the above described resonator is assembled using the aluminum electrodes and its durability is tested, a resonance frequency changes and Q decreases as time passes. The observation of the electrodes of the resonator with a microscope reveals that the electrodes of the reflectors are broken.

Also, the surface acoustic wave filter is assembled and its durability is tested. As in the case of the resonator, a pass band changes and an insertion loss increases. These are also due to the degradation of the electrodes.

One of the reasons why such deterioration appears is that the surface acoustic wave transducer is an electric-mechanical type transducer. The degradation of the electrodes may be caused by electromigration or stress-induced migration. In a case of a small signal input, since an amount of an electric current passing through the electrodes and a mechanical displacement of the surface acoustic wave are small, the electrodes are less degraded. However, when a large signal is inputted or when a large energy is concentrated at a part of the device as in the case of the resonator, the electromigration tends to be induced by the electric current which passes through the electrodes. In addition, the mechanical displacement of the surface acoustic wave increases to induce the stress-induced migration.

In particular, in these years, surface acoustic wave filters are increasingly used as high frequency filters for miniaturizing a mobile telecommunication equipment such as a portable telephone. A high frequency circuit of a telephone system uses a 800-900 MHZ band, and an electrode distance of the surface acoustic wave transducer is about 1 µm. Therefore, the electromigration or stress-induced migration is easily induced. In particular, a filter through which large signals pass uses a piezoelectric material filter having a large volume.

There are some proposals for solving the above problems by selecting or improving an electrode material. For example, an copper-added aluminum electrode is proposed by J. I. Latham, et al, Thin Solid Films, 64, (1979) 9 "Improved Metallization for Surface Acoustic Wave Devices"; IEEE Transactions on Microwave Theory and Technology, "800 MHz High-Performance SAW Filter Using New Resonant Configuration; and Japanese Patent Kokai Publication No. 101413/1982. A titanium-added aluminum electrode is disclosed in Japanese Patent Kokai Publication No. 163408/1987. A zinc-added aluminum electrode is disclosed in Japanese Patent Kokai Publication No. 128607/1989. A silicon-added aluminum electrode is disclosed in Japanese Patent Kokai Publication No. 143016/1985.

However, these aluminum alloy electrodes are not still satisfactory.

### SUMMARY OF THE INVENTION

One object of the present invention is to provide a surface acoustic wave device which can prevent damage of a surface acoustic wave reflector or surface acoustic wave transducer when it is used for a long time under a large electric powder.

Another object of the present invention is to provide a surface acoustic wave device which suffers from small change of characteristics such as decrease of Q, increase of insertion loss or change of a pass band.

According to a first aspect of the present invention, there is provided a surface acoustic wave device comprising a piezoelectric substrate, a surface acoustic wave transducer which is formed on said piezoelectric substrate and converts an input electric signal to a surface acoustic wave to be propagated on a surface of said piezoelectric substrate, and reflectors consisting of metal strips for reflecting said surface acoustic wave which are formed on said piezoelectric substrate and periodically provided with facing said transducer, wherein at least one of said surface acoustic wave transducer and said reflectors comprises an aluminum metal containing 0.01 to 0.5 % by weight of scandium.

According to a second aspect of the present invention, there is provided a surface acoustic wave filter comprising a piezoelectric substrate and at least one pair of surface acoustic wave transducers which are formed on said piezoelectric substrate and covert an input electric signal to a surface acoustic wave to be propagated on a surface of said piezoelectric substrate, wherein said surface acoustic wave transducer comprises an aluminum metal containing 0.01 to 0.5 % by weight of scandium.

### BRIEF DESCRIPTION OF THE DRAWINGS

Fig. 1 is a schematic view of a surface acoustic wave resonator of Example 1,
Fig. 2 is a graph showing a change of resonance frequency with time of the surface acoustic wave resonator in Example 1,
Fig. 3 is a graph showing a change of resonance frequency against a content of scandium in aluminum of the surface acoustic wave resonator in Example 1,
Fig. 4 is a schematic view of a surface acoustic wave filter of Example 2,
Fig. 5 is a graph showing a change of insertion loss with time of the surface acoustic wave filter of Example 2,
Fig. 6 is a graph showing a change of insertion loss against a content of scandium in aluminum of the surface acoustic wave filter in Example 2,
Fig. 7 is a schematic view of a surface acoustic wave resonator of Example 3,
Fig. 8 is a graph showing a change of resonance frequency with time of the surface acoustic wave resonator in Example 3,
Fig. 9 is a schematic view of a surface acoustic wave filter of Example 4,
Fig. 10 is a graph showing a change of insertion loss with time of the surface acoustic wave filter in Example 4,
Fig. 11 is a graph showing a change of resonance frequency with time of the surface acoustic wave resonator in Example 5,
Fig. 12 is a graph showing a change of resonance frequency with time of the surface acoustic wave filter in Example 6,
Fig. 13 is a schematic view of a surface acoustic wave resonator of Example 7,
Fig. 14 is a graph showing a change of resonance frequency with time of the surface acoustic wave resonator in Example 7,
Fig. 15 is a schematic view of a surface acoustic wave filter of Example 8,
Fig. 16 is a graph showing a change of insertion loss with time of the surface acoustic wave filter in Example 8,
Fig. 17 is a graph showing a change of resonance frequency with time of the surface acoustic wave resonator in Example 9,
Fig. 18 is a graph showing a change of resonance frequency with time of the surface acoustic wave resonator in Example 10,
Fig. 19 is a schematic view of a surface acoustic wave resonator of Example 11,
Fig. 20 is a graph showing a change of resonance frequency with time of the surface acoustic wave resonator in Example 11,
Fig. 21 is a schematic view of a surface acoustic wave filter of Example 12,
Fig. 22 is a graph showing a change of insertion loss frequency with time of the surface acoustic wave filter in Example 12,
Fig. 23 is a graph showing a change of resonance frequency with time of the surface acoustic wave resonator in Example 13,
Fig. 24 is a graph showing a change of resonance frequency with time of the surface acoustic wave resonator in Example 14,
Fig. 25 is a schematic view of a surface acoustic wave resonator of Example 15,
Fig. 26 is a graph showing a change of resonance frequency with time of the surface acoustic wave resonator in Example 15,
Fig. 27 is a schematic view of a surface acoustic wave filter of Example 16,
Fig. 28 is a graph showing a change of insertion loss with time of the surface acoustic wave filter in Example 16,
Fig. 29 is a graph showing a change of resonance frequency with time of the surface acoustic wave resonator of Example 17,
Fig. 30 is a graph showing a change of resonance frequency with time of the surface acoustic wave resonator in Example 18,
Fig. 31 is a schematic view of a surface acoustic wave resonator of Example 19,
Fig. 32 is a graph showing a change of resonance frequency with time of the surface acoustic wave resonator in Example 19,
Fig. 33 is a schematic view of a surface acoustic wave filter of Example 20,
Fig. 34 is a graph showing a change of insertion loss with time of the surface acoustic wave filter in Example 20,
Fig. 35 is a graph showing a change of resonance frequency with time of the surface acoustic wave resonator in Example 21,
   and
Fig. 36 is a graph showing a change of resonance frequency with time of the surface acoustic wave device in Example 22.

### DETAILED DESCRIPTION OF THE DRAWINGS

Various embodiments of the surface acoustic wave devices of the present invention will be explained by making reference to the accompanying drawings.

### Example 1

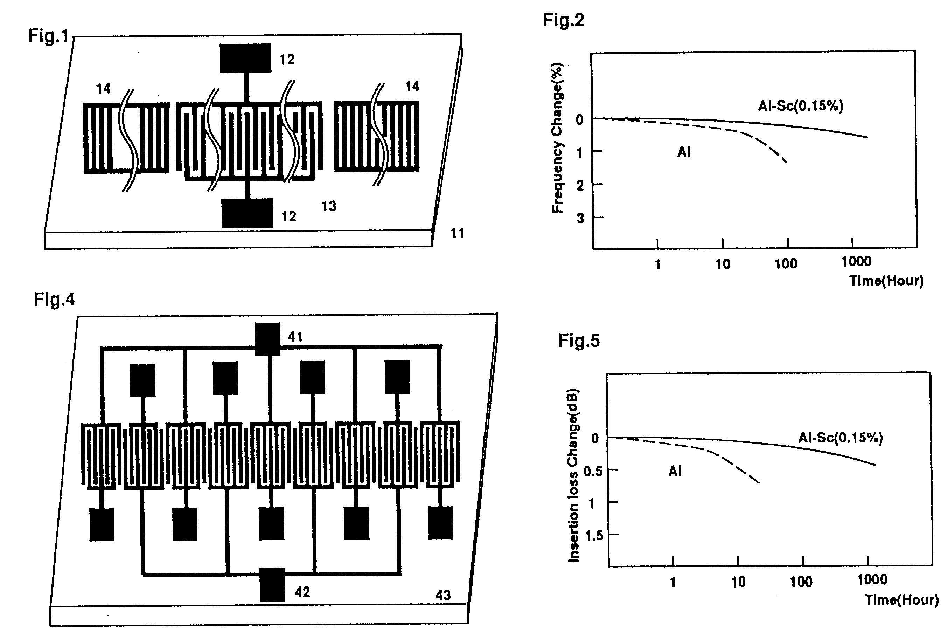

Fig. 1 shows a schematic view of a surface acoustic wave resonator according to the present invention, which comprises a piezoelectric substrate 11, for example, a lithium tantalate substrate, a pair of interdigital transducers 13 which are formed on the piezoelectric substrate 11 and function as surface acoustic wave transducers for converting the electric signal which is inputted from electric terminals 12 to the surface acoustic wave, and grating reflectors 14 which are provided on both sides of the interdigital transducers and reflect the surface acoustic wave back to the interdigital transducers 14.

The grating reflector is formed by arranging plural metal strips each having a width of λ/4 at a distance of λ/2 (λ = a wavelength of the surface acoustic wave) so that the surface acoustic waves reflected by the metal strips are accumulated at the same phase.

In the present invention, electrodes of the surface acoustic wave transducers and the surface acoustic wave reflectors are made of an aluminum metal containing scandium as an impurity.

In this Example, as the piezoelectric substrate, a LiTaO₃ substrate of 36° y-cut and x-propagation was used. The interdigital transducers 13 consisted of 20 pairs of electrode fingers, and each grating reflector 14 consisted of 100 metal short strips. As the electrode metal, aluminum containing 0.15 % by weight of scandium was used.

For comparison, a surface acoustic wave resonator was produced using pure aluminum as the electrode metal.

An electric power of 10 mW was applied to each surface acoustic wave resonator through the terminals 12 and kept standing for 1000 hours. The resonance frequency changed as shown in Fig. 2.

As seen from Fig. 2, the surface acoustic wave resonator of the present invention which used the aluminum containing scandium as the electrode metal had much better durability than the comparative surface acoustic wave resonator which used the pure aluminum as the electrode metal. Though a reason for such effect has not been clarified, the scandium impurity may be deposited on grain boundaries of aluminum to form nuclei and prevent the degradation due to metal fatigue.

To confirm the dependency of the effect of addition of scandium on an amount, several surface acoustic wave resonators were produced with varying an amount of added scandium from 0.01 to 5 % by weight. In this amount range of scandium, the durability of the surface acoustic wave resonators was improved. Fig. 3 shows the change of center frequency after 100 hours. In the above range, the improvement of durability was remarkable in a range between 0.05 % by weight and 0.3 % by weight.

A surface acoustic wave resonator having the same structure as above was produced using the aluminum containing scandium in an amount less than 0.01 % by weight as an electrode metal. Its durability was not significantly improved in comparison with the surface acoustic wave resonator using the pure aluminum electrodes.

A surface acoustic wave resonator having the same structure as above was produced using the aluminum containing more than 5 % by weight of scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 2

A filter for 900 MHz having the structure of Fig. 4 was produced.

To decrease the insertion loss, electrodes were arranged in a multi-electrode structure with 4 input electrodes (41) and 5 output electrodes (42). As the piezoelectric substrate 43, a lithium tantalate substrate of 36° y-cut and x-propagation was used. The surface acoustic wave transducer for input or output consisted of 20 pairs of interdigital transducers. In Fig. 4, only 3.5 pairs of the interdigital transducers were shown for simplicity.

To show the effect of the addition of scandium to the aluminum electrodes, two kinds of surface acoustic wave filters one of which used the aluminum metal containing 0.15 % by weight of scandium and the other of which used the pure aluminum were produced.

To each of the surface acoustic wave filters, the electric power of 2 W was applied and change of the insertion loss was monitored. The results are shown in Fig. 5.

As seen from Fig. 5, when the pure aluminum was used as the electrode metal, the insertion loss greatly degraded as time passed, while when the scandium-added aluminum was used as the electrode metal, the insertion loss did not degraded materially.

The degradation of the insertion loss in the comparative surface acoustic wave resonator should have been caused by the electromigration induced by the application of the high electric power and the stress-induced migration caused by the large dislocation proportional to the large electric power application. In the surface acoustic wave resonator of the present invention, the scandium impurity may be deposited on the grain boundaries of aluminum to form nuclei and prevent the degradation due to metal fatigue.

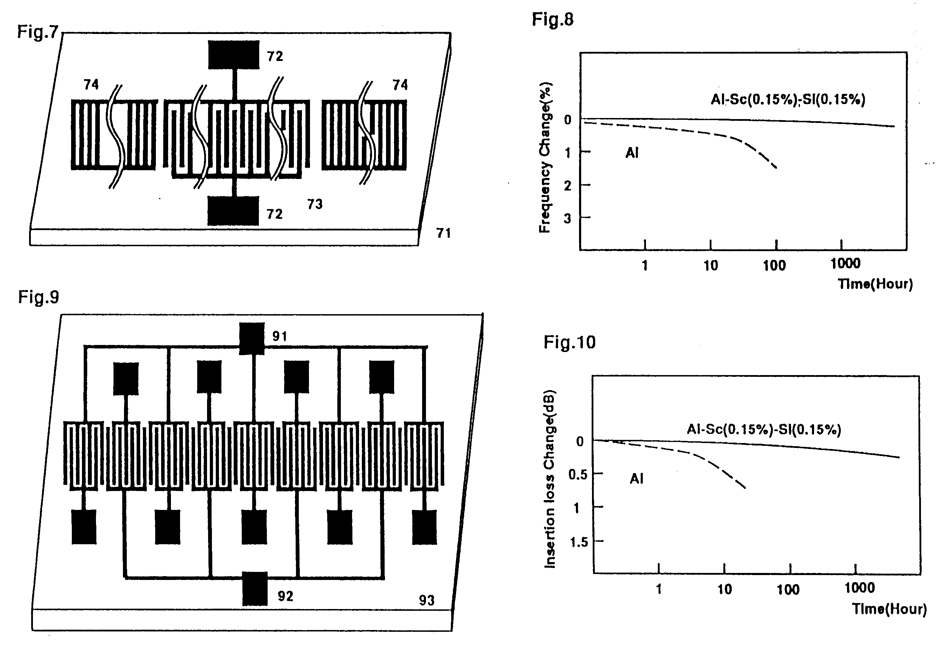

To confirm the dependency of the effect of addition of scandium on an amount, several surface acoustic wave filters were produced with varying an amount of added scandium from 0.01 to 5 % by weight. In this amount range of scandium, the durability of the surface acoustic wave filters was improved. Fig. 6 shows the change of center frequency after 10 hours. In the above range, the improvement of durability was remarkable in a range between 0.05 % by weight and 0.3 % by weight.

A surface acoustic wave filter having the same structure as above was produced using the aluminum containing scandium in an amount less than 0.01 % by weight as an electrode metal. Its durability was not significantly improved in comparison with the surface acoustic wave filter using the pure aluminum electrodes.

A surface acoustic wave filter having the same structure as above was produced using the aluminum containing more than 5 % by weight of scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 3

Fig. 7 shows a schematic view of another example of a surface acoustic wave resonator according to the present invention, which comprises a piezoelectric substrate 71 made of, for example, a lithium tantalate substrate, a pair of interdigital transducers 73 which are formed on the piezoelectric substrate 71 and function as surface acoustic wave transducers for converting the electric signal which is inputted from electric terminals 72 to the surface acoustic wave, and grating reflectors 74 which are provided on both sides of the interdigital transducers and reflect the surface acoustic wave back to the interdigital transducers 73.

The grating reflector is formed by arranging plural metal strips each having a width of λ/4 at a distance of λ/2 so that the surface acoustic waves reflected by the metal strips are accumulated at the same phase.

In this Example, electrodes of the surface acoustic wave transducers and the surface acoustic wave reflectors were made of an aluminum metal containing silicon and scandium as impurities.

As the piezoelectric substrate, a LiTaO₃ substrate of 36° y-cut and x-propagation was used. The interdigital transducers 73 consisted of 20 pairs of electrode fingers, and each grating reflector 74 consisted of 100 metal short strips. As the electrode metal, aluminum containing 0.15 % by weight of silicon and 0.15 % by weight of scandium was used.

For comparison, a surface acoustic wave resonator was produced using pure aluminum as the electrode metal.

An electric power of 10 mW was applied to each surface acoustic wave resonator through the terminals 12 and kept standing for 1000 hours. The resonance frequency changed as shown in Fig. 8.

As seen from Fig. 8, the surface acoustic wave resonator of the present invention which used the aluminum containing silicon and scandium as the electrode metal had much better durability than the comparative surface acoustic wave resonator which used the pure aluminum as the electrode metal. Though a reason for such effect has not been clarified, the silicon and scandium impurities may be deposited on the grain boundaries of aluminum to form nuclei and prevent the degradation due to metal fatigue.

To confirm the dependency of the effect of addition of silicon and scandium on amounts, several surface acoustic wave resonators were produced with varying an amount of added silicon or scandium from 0.01 to 5 % by weight. In this amount range of silicon or scandium, the durability of the surface acoustic wave resonators was improved. In the above ranges the improvement of durability was remarkable in a range between 0.05 % by weight and 0.3 % by weight of scandium.

A surface acoustic wave resonator having the same structure as above was produced using the aluminum containing silicon and scandium in an amount less than 0.01 % by weight as an electrode metal. Its durability was not significantly improved in comparison with the surface acoustic wave resonator using the pure aluminum electrodes.

A surface acoustic wave resonator having the same structure as above was produced using the aluminum containing more than 5 % by weight of silicon and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 4

A filter for 900 MHz having the structure of Fig. 9 was produced.

To decrease the insertion loss, electrodes were arranged in a multi-electrode structure with 4 input electrodes (91) and 5 output electrodes (92). As the piezoelectric substrate 93, a lithium tantalate substrate of 36° y-cut and x-propagation was used. The surface acoustic wave transducer for input or output consisted of 20 pairs of interdigital transducers. In Fig. 9, only 3.5 pairs of the interdigital transducers were shown for simplicity.

To show the effect of the addition of silicon and scandium to the aluminum electrodes, two kinds of surface acoustic wave filters one of which used the aluminum metal containing 0.15 % by weight of silicon and 0.15 % by weight of scandium and the other of which used the pure aluminum were produced.

To each of the surface acoustic wave filters, the electric power of 2 W was applied and change of the insertion loss was monitored. The results are shown in Fig. 10.

As seen from Fig. 10, when the pure aluminum was used as the electrode metal, the insertion loss greatly degraded as time passed, while when the silicon/scandium-added aluminum was used as the electrode metal, the insertion loss did not degraded materially.

The degradation of the insertion loss in the comparative surface acoustic wave resonator should have been caused by the electromigration induced by the application of the high electric power and the stress-induced migration caused by the large dislocation proportional to the large electric power application. In the surface acoustic wave resonator of the present invention, the silicon and scandium impurities may be deposited on the grain boundaries of aluminum to form nuclei and prevent the degradation due to metal fatigue.

To confirm the dependency of the effect of addition of scandium on an amount, several surface acoustic wave filters were produced with varying an amount of added silicon and scandium from 0.01 to 5 % by weight. In this amount range of scandium, the durability of the surface acoustic wave filters was improved. In the above range, the improvement of durability was remarkable in a range between 0.05 % by weight and 0.3 % by weight of scandium.

A surface acoustic wave filter having the same structure as above was produced using the aluminum containing silicon and scandium in an amount less than 0.01 % by weight as an electrode metal. Its durability was not significantly improved in comparison with the surface acoustic wave resonator using the pure aluminum electrodes.

A surface acoustic wave filter having the same structure as above was produced using the aluminum containing more than 5 % by weight of silicon and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 5

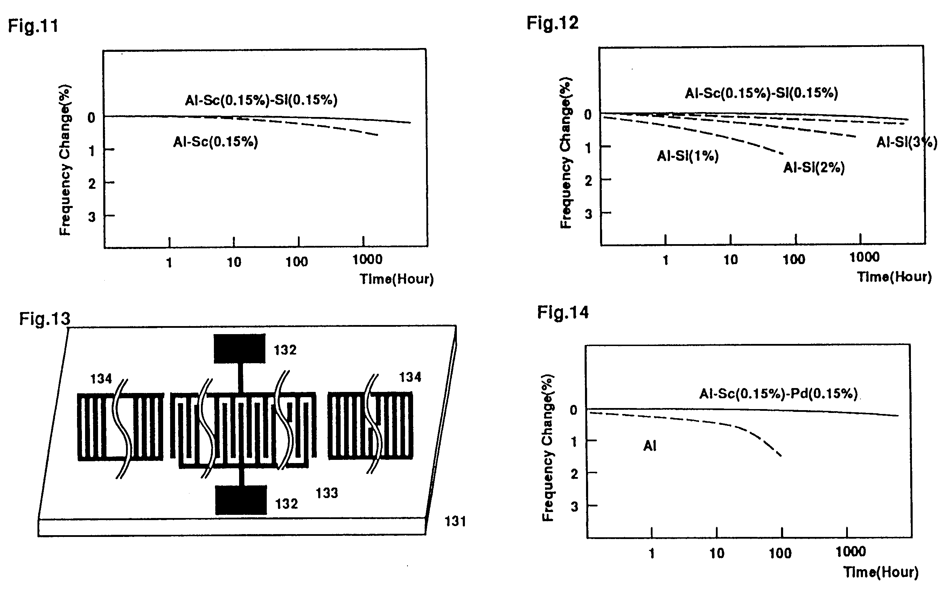

In the same manner as in Example 1 except that 0.15 % by weight of scandium was added to the aluminum metal or 0.15 % by weight of scandium and 0.15 % by weight of silicon were added to the aluminum metal to confirm the effect of the addition of silicon, a surface acoustic wave resonator having the structure of Fig. 7 was produced. Then, the durability of each surface acoustic wave resonator was evaluated in the same manner as in Example 1. The results are shown in Fig. 11. The effect of the addition of silicon was confirmed.

Several surface acoustic wave filters were produced with varying an amount of added each of silicon and scandium from 0.01 to 5 % by weight. In this amount range of silicon and scandium, the durability of the surface acoustic wave filters was improved. In the above range, the improvement of durability was remarkable in a range between 0.05 % by weight and 0.3 % by weight of scandium.

### Example 6

In the same manner as in Example 1 except that silicon alone was added to the aluminum metal or scandium and silicon were added to the aluminum metal to confirm the effect of the addition of scandium, a surface acoustic wave resonator was produced. Then, the durability of each surface acoustic wave resonator was evaluated in the same manner as in Example 1. The results are shown in Fig. 12. In order to achieve the same result as achieved by the aluminum metal containing 0.15 % by weight of scandium and 0.15 % by weight of silicon, the aluminum metal containing 3 % by weight of silicon only should have been used as the electrode metal. When the characteristics of the two surface acoustic wave resonators were compared, the difference due to the electrode resistances was found. That is, the surface acoustic wave resonator using the aluminum metal containing 0.15 % by weight of scandium and 0.15 % by weight of silicon had better performances than one using the aluminum metal containing only silicon.

With varying the amount of the added scandium, several experiments were carried out. In any case, to achieve the same effect as that achieved by the aluminum metal containing both scandium and silicon, a larger amount of silicon should have been added to the aluminum metal when silicon alone was added. When silicon alone was added, the characteristics were degraded due to the increase of electrode resistance.

### Example 7

Fig. 13 shows a schematic view of a further example of a surface acoustic wave resonator according to the present invention, which comprises a piezoelectric substrate 131 made of, for example, a lithium tantalate substrate, a pair of interdigital transducers 133 which are formed on the piezoelectric substrate 131 and function as surface acoustic wave transducers for converting the electric signal which is inputted from electric terminals 132 to the surface acoustic wave, and grating reflectors 134 which are provided on both sides of the interdigital transducers and reflect the surface acoustic wave back to the interdigital transducers 133.

The grating reflector is formed by arranging plural metal strips each having a width of λ/4 at a distance of λ/2 so that the surface acoustic waves reflected by the metal strips are accumulated at the same phase.

In this Example, electrodes of the surface acoustic wave transducers and the surface acoustic wave reflectors were made of an aluminum metal containing palladium and scandium as impurities.

As the piezoelectric substrate, a LiTaO₃ substrate of 36° y-cut and x-propagation was used. The interdigital transducers 133 consisted of 20 pairs of electrode fingers, and each grating reflector 134 consisted of 100 metal short strips. As the electrode metal, aluminum containing 0.15 % by weight of palladium and 0.15 % by weight of scandium was used.

For comparison, a surface acoustic wave resonator was produced using pure aluminum as the electrode metal.

An electric power of 10 mW was applied to each surface acoustic wave resonator through the terminals 12 and kept standing for 1000 hours. The resonance frequency changed as shown in Fig. 14.

As seen from Fig. 14, the surface acoustic wave resonator of the present invention which used the aluminum containing palladium and scandium as the electrode metal had much better durability than the comparative surface acoustic wave resonator which used the pure aluminum as the electrode metal. Though a reason for such effect has not been clarified, the palladium and scandium impurities may be deposited on the grain boundaries of aluminum to form nuclei and prevent the degradation due to metal fatigue.

To confirm the dependency of the effect of addition of palladium and scandium on amounts, several surface acoustic wave resonators were produced with varying an amount of added palladium or scandium from 0.01 to 5 % by weight. In this amount range of palladium or scandium, the durability of the surface acoustic wave resonators was improved. In the above ranges the improvement of durability was remarkable in a range between 0.05 % by weight and 0.3 % by weight of scandium.

A surface acoustic wave resonator having the same structure as above was produced using the aluminum containing palladium and scandium in an amount less than 0.01 % by weight as an electrode metal. Its durability was not significantly improved in comparison with the surface acoustic wave resonator using the pure aluminum electrodes.

A surface acoustic wave resonator having the same structure as above was produced using the aluminum containing more than 5 % by weight of palladium and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 8

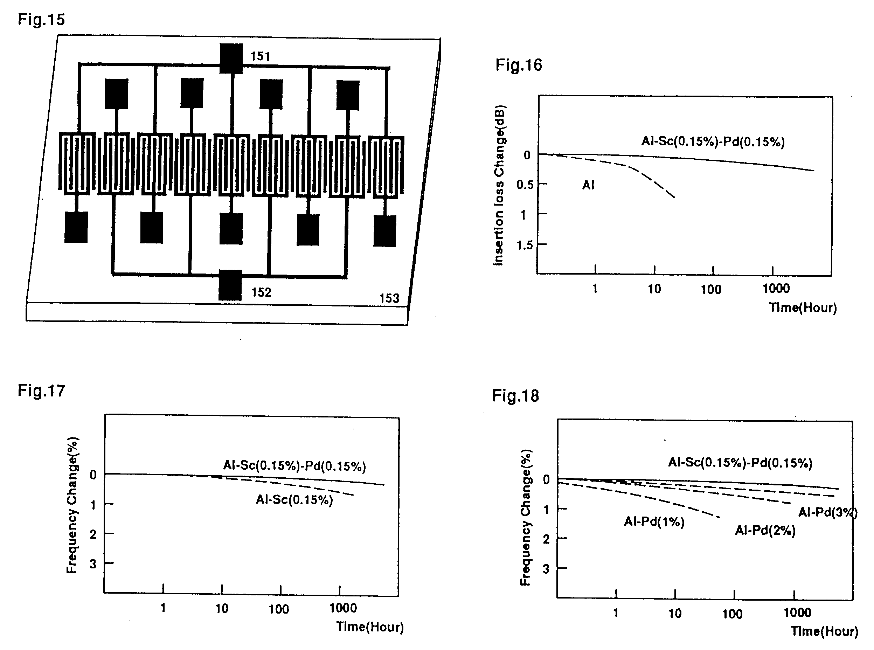

A filter for 900 MHz having the structure of Fig. 15 was produced.

To decrease the insertion loss, electrodes were arranged in a multi-electrode structure with 4 input electrodes (151) and 5 output electrodes (152). As the piezoelectric substrate 153, a lithium tantalate substrate of 36° y-cut and x-propagation was used. The surface acoustic wave transducer for input or output consisted of 20 pairs of interdigital transducers. In Fig. 15, only 3.5 pairs of the interdigital transducers were shown for simplicity.

To show the effect of the addition of palladium and scandium to the aluminum electrodes, two kinds of surface acoustic wave filters one of which used the aluminum metal containing 0.15 % by weight of palladium and 0.15 % by weight of scandium and the other of which used the pure aluminum were produced.

To each of the surface acoustic wave filters, the electric power of 2 W was applied and change of the insertion loss was monitored. The results are shown in Fig. 16.

As seen from Fig. 10, when the pure aluminum was used as the electrode metal, the insertion loss greatly degraded as time passed, while when the palladium/scandium-added aluminum was used as the electrode metal, the insertion loss did not degraded materially.

The degradation of the insertion loss in the comparative surface acoustic wave resonator should have been caused by the electromigration induced by the application of the high electric power and the stress-induced migration caused by the large dislocation proportional to the large electric power application. In the surface acoustic wave resonator of the present invention, the palladium and scandium impurities may be deposited on the grain boundaries of aluminum to form nuclei and prevent the degradation due to metal fatigue.

To confirm the dependency of the effect of addition of scandium on an amount, several surface acoustic wave filters were produced with varying an amount of added palladium and scandium from 0.01 to 5 % by weight. In this amount range of scandium, the durability of the surface acoustic wave filters was improved. In the above range, the improvement of durability was remarkable in a range between 0.05 % by weight and 0.3 % by weight of scandium.

A surface acoustic wave filter having the same structure as above was produced using the aluminum containing palladium and scandium in an amount less than 0.01 % by weight as an electrode metal. Its durability was not significantly improved in comparison with the surface acoustic wave resonator using the pure aluminum electrodes.

A surface acoustic wave filter having the same structure as above was produced using the aluminum containing more than 5 % by weight of palladium and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 9

In the same manner as in Example 1 except that 0.15 % by weight of scandium only was added to the aluminum metal or 0.15 % by weight of scandium and 0.15 % by weight of palladium were added to the aluminum metal to confirm the effect of the addition of palladium, a surface acoustic wave resonator having the structure of Fig. 13 was produced. Then, the durability of each surface acoustic wave resonator was evaluated in the same manner as in Example 1. The results are shown in Fig. 17. The effect of the addition of palladium was confirmed.

Several surface acoustic wave filters were produced with varying an amount of added each of palladium and scandium from 0.01 to 5 % by weight. In this amount range of palladium and scandium, the durability of the surface acoustic wave filters was improved. In the above range, the improvement of durability was remarkable in a range between 0.05 % by weight and 0.3 % by weight of scandium.

### Example 10

In the same manner as in Example 1 except that palladium alone was added to the aluminum metal or scandium and palladium were added to the aluminum metal to confirm the effect of the addition of scandium, a surface acoustic wave resonator was produced. Then, the durability of each surface acoustic wave resonator was evaluated in the same manner as in Example 1. The results are shown in Fig. 18. In order to achieve the same result as achieved by the aluminum metal containing 0.15 % by weight of scandium and 0.15 % by weight of palladium, the aluminum metal containing 3 % by weight of palladium only should have been used as the electrode metal. When the characteristics of the two surface acoustic wave resonators were compared, the difference due to the electrode resistances was found. That is, the surface acoustic wave resonator using the aluminum metal containing 0.15 % by weight of scandium and 0.15 % by weight of palladium had better performances than one using the aluminum metal containing only palladium.

With varying the amount of the added scandium, several experiments were carried out. In any case, to achieve the same effect as that achieved by the aluminum metal containing both scandium and palladium, a larger amount of palladium should have been added to the aluminum metal when palladium alone was added. When palladium alone was added, the characteristics were degraded due to the increase of electrode resistance.

### Example 11

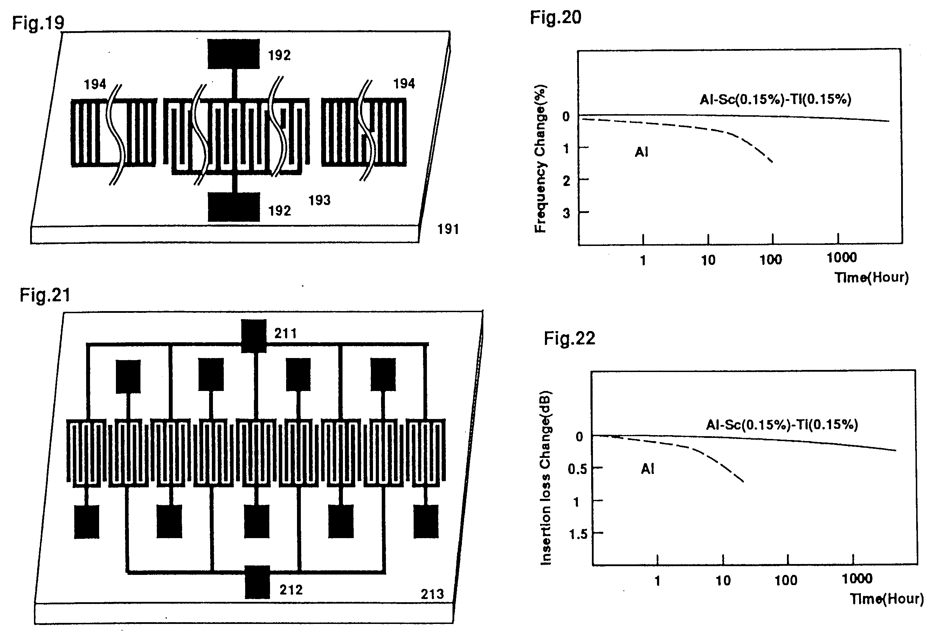

Fig. 19 shows a schematic view of yet another example of a surface acoustic wave resonator according to the present invention, which comprises a piezoelectric substrate 191 made of, for example, a lithium tantalate substrate, a pair of interdigital transducers 193 which are formed on the piezoelectric substrate 191 and function as surface acoustic wave transducers for converting the electric signal which is inputted from electric terminals 192 to the surface acoustic wave, and grating reflectors 74 which are provided on both sides of the interdigital transducers and reflect the surface acoustic wave back to the interdigital transducers 193.

The grating reflector is formed by arranging plural metal strips each having a width of λ/4 at a distance of λ/2 so that the surface acoustic waves reflected by the metal strips are accumulated at the same phase.

In this Example, electrodes of the surface acoustic wave transducers and the surface acoustic wave reflectors were made of an aluminum metal containing titanium and scandium as impurities.

As the piezoelectric substrate, a LiTaO₃ substrate of 36° y-cut and x-propagation was used. The interdigital transducers 193 consisted of 20 pairs of electrode fingers, and each grating reflector 194 consisted of 100 metal short strips. As the electrode metal, aluminum containing 0.15 % by weight of titanium and 0.15 % by weight of scandium was used.

For comparison, a surface acoustic wave resonator was produced using pure aluminum as the electrode metal.

An electric power of 10 mW was applied to each surface acoustic wave resonator through the terminals 12 and kept standing for 1000 hours. The resonance frequency changed as shown in Fig. 20.

As seen from Fig. 20, the surface acoustic wave resonator of the present invention which used the aluminum containing titanium and scandium as the electrode metal had much better durability than the comparative surface acoustic wave resonator which used the pure aluminum as the electrode metal. Though a reason for such effect has not been clarified, the titanium and scandium impurities may be deposited on the grain boundaries of aluminum to form nuclei and prevent the degradation due to metal fatigue.

To confirm the dependency of the effect of addition of titanium and scandium on amounts, several surface acoustic wave resonators were produced with varying an amount of added titanium or scandium from 0.01 to 5 % by weight. In this amount range of titanium or scandium, the durability of the surface acoustic wave resonators was improved. In the above ranges the improvement of durability was remarkable in a range between 0.05 % by weight and 0.3 % by weight of scandium.

A surface acoustic wave resonator having the same structure as above was produced using the aluminum containing titanium and scandium in an amount less than 0.01 % by weight as an electrode metal. Its durability was not significantly improved in comparison with the surface acoustic wave resonator using the pure aluminum electrodes.

A surface acoustic wave resonator having the same structure as above was produced using the aluminum containing more than 5 % by weight of titanium and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 12

A filter for 900 MHz having the structure of Fig. 21 was produced.

To decrease the insertion loss, electrodes were arranged in a multi-electrode structure with 4 input electrodes (211) and 5 output electrodes (212). As the piezoelectric substrate 213, a lithium tantalate substrate of 36° y-cut and x-propagation was used. The surface acoustic wave transducer consisted of 20 pairs of interdigital transducers. In Fig. 21, only 3.5 pairs of the interdigital transducers were shown for simplicity.

To show the effect of the addition of titanium and scandium to the aluminum electrodes, two kinds of surface acoustic wave filters one of which used the aluminum metal containing 0.15 % by weight of titanium and 0.15 % by weight of scandium and the other of which used the pure aluminum were produced.

To each of the surface acoustic wave filters, the electric power of 2 W was applied and change of the insertion loss was monitored. The results are shown in Fig. 22.

As seen from Fig. 22, when the pure aluminum was used as the electrode metal, the insertion loss greatly degraded as time passed, while when the titanium/scandium-added aluminum was used as the electrode metal, the insertion loss did not degraded materially.

The degradation of the insertion loss in the comparative surface acoustic wave resonator should have been caused by the electromigration induced by the application of the high electric power and the stress-induced migration caused by the large dislocation proportional to the large electric power application. In the surface acoustic wave resonator of the present invention, the titanium and scandium impurities may be deposited on the grain boundaries of aluminum to form nuclei and prevent the degradation due to metal fatigue.

To confirm the dependency of the effect of addition of scandium on an amount, several surface acoustic wave filters were produced with varying an amount of added titanium and scandium from 0.01 to 5 % by weight. In this amount range of scandium, the durability of the surface acoustic wave filters was improved. In the above range, the improvement of durability was remarkable in a range between 0.05 % by weight and 0.3 % by weight of scandium.

A surface acoustic wave filter having the same structure as above was produced using the aluminum containing titanium and scandium in an amount less than 0.01 % by weight as an electrode metal. Its durability was not significantly improved in comparison with the surface acoustic wave resonator using the pure aluminum electrodes.

A surface acoustic wave filter having the same structure as above was produced using the aluminum containing more than 5 % by weight of titanium and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 13

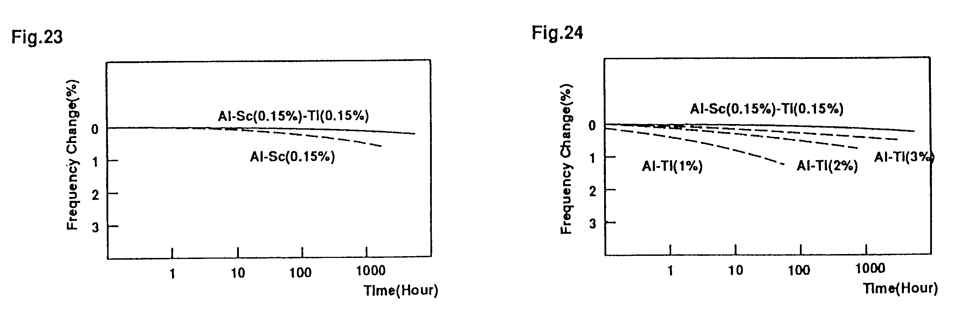

In the same manner as in Example 1 except that 0.15 % by weight of scandium was added to the aluminum metal or 0.15 % by weight of scandium and 0.15 % by weight of titanium were added to the aluminum metal to confirm the effect of the addition of titanium, a surface acoustic wave resonator having the structure of Fig. 19 was produced. Then, the durability of each surface acoustic wave resonator was evaluated in the same manner as in Example 1. The results are shown in Fig. 23. The effect of the addition of titanium was confirmed.

Several surface acoustic wave filters were produced with varying an amount of added each of titanium and scandium from 0.01 to 5 % by weight. In this amount range of titanium and scandium, the durability of the surface acoustic wave filters was improved. In the above range, the improvement of durability was remarkable in a range between 0.05 % by weight and 0.3 % by weight of scandium.

### Example 14

In the same manner as in Example 1 except that titanium alone was added to the aluminum metal or scandium and titanium were added to the aluminum metal to confirm the effect of the addition of scandium, a surface acoustic wave resonator was produced. Then, the durability of each surface acoustic wave resonator was evaluated in the same manner as in Example 1. The results are shown in Fig. 24. In order to achieve the same result as achieved by the aluminum metal containing 0.15 % by weight of scandium and 0.15 % by weight of titanium, the aluminum metal containing 3 % by weight of titanium only should have been used as the electrode metal. When the characteristics of the two surface acoustic wave resonators were compared, the difference due to the electrode resistances was found. That is, the surface acoustic wave resonator using the aluminum metal containing 0.15 % by weight of scandium and 0.15 % by weight of titanium had better performances than one using the aluminum metal containing only titanium.

With varying the amount of the added scandium, several experiments were carried out. In any case, to achieve the same effect as that achieved by the aluminum metal containing both scandium and titanium, a larger amount of titanium should have been added to the aluminum metal when titanium alone was added. When titanium alone was added, the characteristics were degraded due to the increase of electrode resistance.

### Example 15

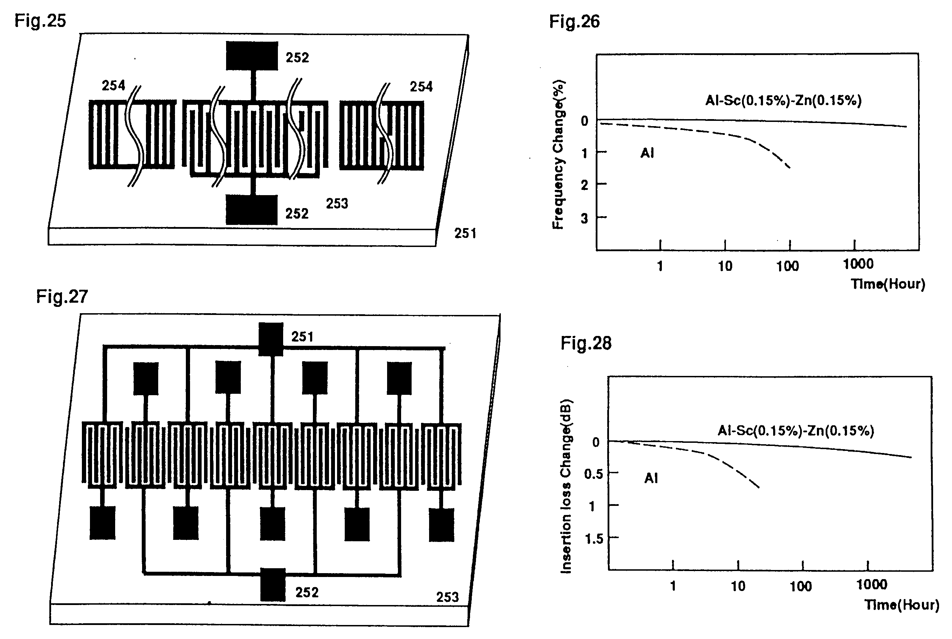

Fig. 25 shows a schematic view of an additional example of a surface acoustic wave resonator according to the present invention, which comprises a piezoelectric substrate 251 made of, for example, a lithium tantalate substrate, a pair of interdigital transducers 253 which are formed on the piezoelectric substrate 251 and function as surface acoustic wave transducers for converting the electric signal which is inputted from electric terminals 252 to the surface acoustic wave, and grating reflectors 254 which are provided on both sides of the interdigital transducers and reflect the surface acoustic wave back to the interdigital transducers 253.

The grating reflector is formed by arranging plural metal strips each having a width of λ/4 at a distance of λ/2 so that the surface acoustic waves reflected by the metal strips are accumulated at the same phase.

In this Example, electrodes of the surface acoustic wave transducers and the surface acoustic wave reflectors were made of an aluminum metal containing zinc and scandium as impurities.

As the piezoelectric substrate, a LiTaO₃ substrate of 36° y-cut and x-propagation was used. The interdigital transducers 253 consisted of 20 pairs of electrode fingers, and each grating reflector 254 consisted of 100 metal short strips. As the electrode metal, aluminum containing 0.15 % by weight of zinc and 0.15 % by weight of scandium was used.

For comparison, a surface acoustic wave resonator was produced using pure aluminum as the electrode metal.

An electric power of 10 mW was applied to each surface acoustic wave resonator through the terminals 12 and kept standing for 1000 hours. The resonance frequency changed as shown in Fig. 26.

As seen from Fig. 26, the surface acoustic wave resonator of the present invention which used the aluminum containing zinc and scandium as the electrode metal had much better durability than the comparative surface acoustic wave resonator which used the pure aluminum as the electrode metal. Though a reason for such effect has not been clarified, the zinc and scandium impurities may be deposited on the grain boundaries of aluminum to form nuclei and prevent the degradation due to metal fatigue.

To confirm the dependency of the effect of addition of zinc and scandium on amounts, several surface acoustic wave resonators were produced with varying an amount of added zinc or scandium from 0.01 to 5 % by weight. In this amount range of zinc or scandium, the durability of the surface acoustic wave resonators was improved. In the above ranges the improvement of durability was remarkable in a range between 0.05 % by weight and 0.3 % by weight of scandium.

A surface acoustic wave resonator having the same structure as above was produced using the aluminum containing zinc and scandium in an amount less than 0.01 % by weight as an electrode metal. Its durability was not significantly improved in comparison with the surface acoustic wave resonator using the pure aluminum electrodes.

A surface acoustic wave resonator having the same structure as above was produced using the aluminum containing more than 5 % by weight of zinc and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 16

A filter for 900 MHz having the structure of Fig. 27 was produced.

To decrease the insertion loss, electrodes were arranged in a multi-electrode structure with 4 input electrodes (271) and 5 output electrodes (272). As the piezoelectric substrate 273, a lithium tantalate substrate of 36° y-cut and x-propagation was used. The surface acoustic wave transducer for input or output consisted of 20 pairs of interdigital transducers. In Fig. 27, only 3.5 pairs of the interdigital transducers were shown for simplicity.

To show the effect of the addition of zinc and scandium to the aluminum electrodes, two kinds of surface acoustic wave filters one of which used the aluminum metal containing 0.15 % by weight of zinc and 0.15 % by weight of scandium and the other of which used the pure aluminum were produced.

To each of the surface acoustic wave filters, the electric power of 2 W was applied and change of the insertion loss was monitored. The results are shown in Fig. 28.

As seen from Fig. 28, when the pure aluminum was used as the electrode metal, the insertion loss greatly degraded as time passed, while when the zinc/scandium-added aluminum was used as the electrode metal, the insertion loss did not degraded materially.

The degradation of the insertion loss in the comparative surface acoustic wave resonator should have been caused by the electromigration induced by the application of the high electric power and the stress-induced migration caused by the large dislocation proportional to the large electric power application. In the surface acoustic wave resonator of the present invention, the zinc and scandium impurities may be deposited on the grain boundaries of aluminum to form nuclei and prevent the degradation due to metal fatigue.

To confirm the dependency of the effect of addition of scandium on an amount, several surface acoustic wave filters were produced with varying an amount of added zinc and scandium from 0.01 to 5 % by weight. In this amount range of scandium, the durability of the surface acoustic wave filters was improved. In the above range, the improvement of durability was remarkable in a range between 0.05 % by weight and 0.3 % by weight of scandium.

A surface acoustic wave filter having the same structure as above was produced using the aluminum containing zinc and scandium in an amount less than 0.01 % by weight as an electrode metal. Its durability was not significantly improved in comparison with the surface acoustic wave resonator using the pure aluminum electrodes.

A surface acoustic wave filter having the same structure as above was produced using the aluminum containing more than 5 % by weight of zinc and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 17

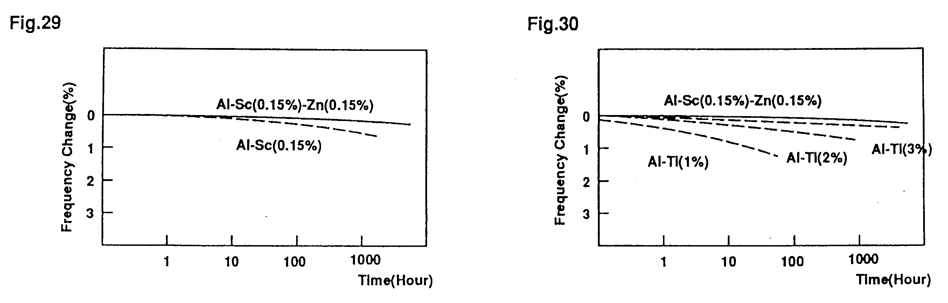

In the same manner as in Example 1 except that 0.15 % by weight of scandium was added to the aluminum metal or 0.15 % by weight of scandium and 0.15 % by weight of zinc were added to the aluminum metal to confirm the effect of the addition of zinc, a surface acoustic wave resonator having the structure of Fig. 25 was produced. Then, the durability of each surface acoustic wave resonator was evaluated in the same manner as in Example 1. The results are shown in Fig. 29. The effect of the addition of zinc was confirmed.

Several surface acoustic wave filters were produced with varying an amount of added each of zinc and scandium from 0.01 to 5 % by weight. In this amount range of zinc and scandium, the durability of the surface acoustic wave filters was improved. In the above range, the improvement of durability was remarkable in a range between 0.05 % by weight and 0.3 % by weight of scandium.

### Example 18

In the same manner as in Example 1 except that zinc alone was added to the aluminum metal or scandium and zinc were added to the aluminum metal to confirm the effect of the addition of scandium, a surface acoustic wave resonator was produced. Then, the durability of each surface acoustic wave resonator was evaluated in the same manner as in Example 1. The results are shown in Fig. 30. In order to achieve the same result as achieved by the aluminum metal containing 0.15 % by weight of scandium and 0.15 % by weight of zinc, the aluminum metal containing 3 % by weight of zinc only should have been used as the electrode metal. When the characteristics of the two surface acoustic wave resonators were compared, the difference due to the electrode resistances was found. That is, the surface acoustic wave resonator using the aluminum metal containing 0.15 % by weight of scandium and 0.15 % by weight of zinc had better performances than one using the aluminum metal containing only zinc.

With varying the amount of the added scandium, several experiments were carried out. In any case, to achieve the same effect as that achieved by the aluminum metal containing both scandium and zinc, a larger amount of zinc should have been added to the aluminum metal when zinc alone was added. When zinc alone was added, the characteristics were degraded due to the increase of electrode resistance.

### Example 19

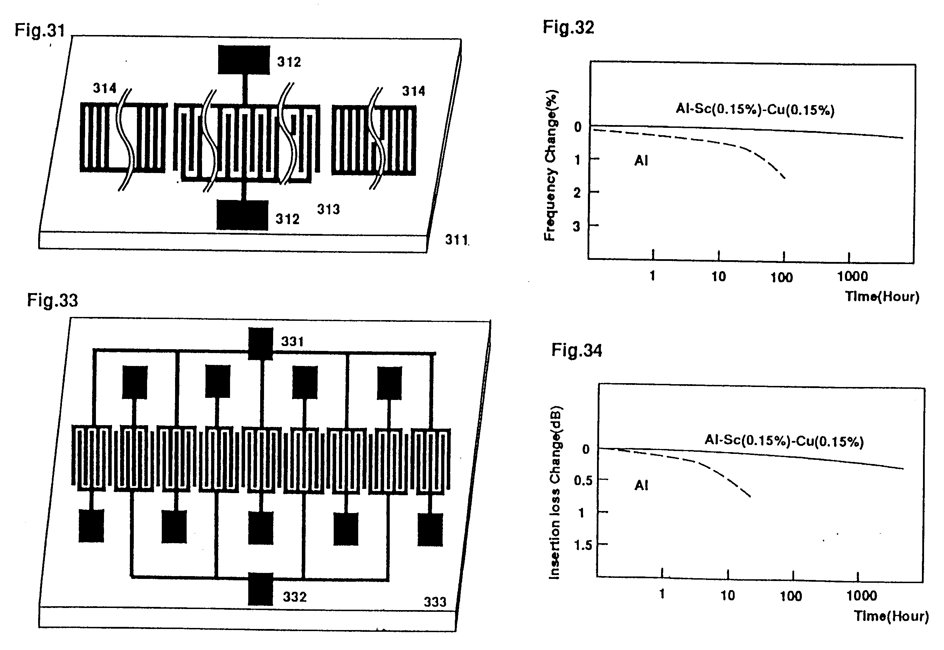

Fig. 31 shows a schematic view of another example of a surface acoustic wave resonator according to the present invention, which comprises a piezoelectric substrate 311 made of, for example, a lithium tantalate substrate, a pair of interdigital transducers 313 which are formed on the piezoelectric substrate 311 and function as surface acoustic wave transducers for converting the electric signal which is inputted from electric terminals 312 to the surface acoustic wave, and grating reflectors 314 which are provided on both sides of the interdigital transducers and reflect the surface acoustic wave back to the interdigital transducers 313.

The grating reflector is formed by arranging plural metal strips each having a width of λ/4 at a distance of λ/2 so that the surface acoustic waves reflected by the metal strips are accumulated at the same phase.

In this Example, electrodes of the surface acoustic wave transducers and the surface acoustic wave reflectors were made of an aluminum metal containing copper and scandium as impurities.

As the piezoelectric substrate, a LiTaO₃ substrate of 36° y-cut and x-propagation was used. The interdigital transducers 313 consisted of 20 pairs of electrode fingers, and each grating reflector 314 consisted of 100 metal short strips. As the electrode metal, aluminum containing 0.15 % by weight of copper and 0.15 % by weight of scandium was used.

For comparison, a surface acoustic wave resonator was produced using pure aluminum as the electrode metal.

An electric power of 10 mW was applied to each surface acoustic wave resonator through the terminals 312 and kept standing for 1000 hours. The resonance frequency changed as shown in Fig. 32.

As seen from Fig. 32, the surface acoustic wave resonator of the present invention which used the aluminum containing copper and scandium as the electrode metal had much better durability than the comparative surface acoustic wave resonator which used the pure aluminum as the electrode metal. Though a reason for such effect has not been clarified, the copper and scandium impurities may be deposited on the grain boundaries of aluminum to form nuclei and prevent the degradation due to metal fatigue.

To confirm the dependency of the effect of addition of copper and scandium on amounts, several surface acoustic wave resonators were produced with varying an amount of added copper or scandium from 0.01 to 5 % by weight. In this amount range of copper or scandium, the durability of the surface acoustic wave resonators was improved. In the above ranges the improvement of durability was remarkable in a range between 0.05 % by weight and 0.3 % by weight of scandium.

A surface acoustic wave resonator having the same structure as above was produced using the aluminum containing copper and scandium in an amount less than 0.01 % by weight as an electrode metal. Its durability was not significantly improved in comparison with the surface acoustic wave resonator using the pure aluminum electrodes.

A surface acoustic wave resonator having the same structure as above was produced using the aluminum containing more than 5 % by weight of copper and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 20

A filter for 900 MHz having the structure of Fig. 33 was produced.

To decrease the insertion loss, electrodes were arranged in a multi-electrode structure with 4 input electrodes (331) and 5 output electrodes (332). As the piezoelectric substrate 333, a lithium tantalate substrate of 36° y-cut and x-propagation was used. The surface acoustic wave transducer for input or output consisted of 20 pairs of interdigital transducers. In Fig. 33, only 3.5 pairs of the interdigital transducers were shown for simplicity.

To show the effect of the addition of copper and scandium to the aluminum electrodes, two kinds of surface acoustic wave filters one of which used the aluminum metal containing 0.15 % by weight of copper and 0.15 % by weight of scandium and the other of which used the pure aluminum were produced.

To each of the surface acoustic wave filters, the electric power of 2 W was applied and change of the insertion loss was monitored. The results are shown in Fig. 34.

As seen from Fig. 34, when the pure aluminum was used as the electrode metal, the insertion loss greatly degraded as time passed, while when the copper/scandium-added aluminum was used as the electrode metal, the insertion loss did not degraded materially.

The degradation of the insertion loss in the comparative surface acoustic wave resonator should have been caused by the electromigration induced by the application of the high electric power and the stress-induced migration caused by the large dislocation proportional to the large electric power application. In the surface acoustic wave resonator of the present invention, the copper and scandium impurities may be deposited on the grain boundaries of aluminum to form nuclei and prevent the degradation due to metal fatigue.

To confirm the dependency of the effect of addition of scandium on an amount, several surface acoustic wave filters were produced with varying an amount of added copper and scandium from 0.01 to 5 % by weight. In this amount range of scandium, the durability of the surface acoustic wave filters was improved. In the above range, the improvement of durability was remarkable in a range between 0.05 % by weight and 0.3 % by weight of scandium.

A surface acoustic wave filter having the same structure as above was produced using the aluminum containing copper and scandium in an amount less than 0.01 % by weight as an electrode metal. Its durability was not significantly improved in comparison with the surface acoustic wave resonator using the pure aluminum electrodes.

A surface acoustic wave filter having the same structure as above was produced using the aluminum containing more than 5 % by weight of copper and scandium as an electrode metal. But, the characteristics were more deteriorated than the surface acoustic wave resonator using the pure aluminum electrodes, which might be due to the increase of the resistance in the electrodes. In addition, the production was difficult. Therefore, this surface acoustic wave resonator was not practically attractive.

### Example 21

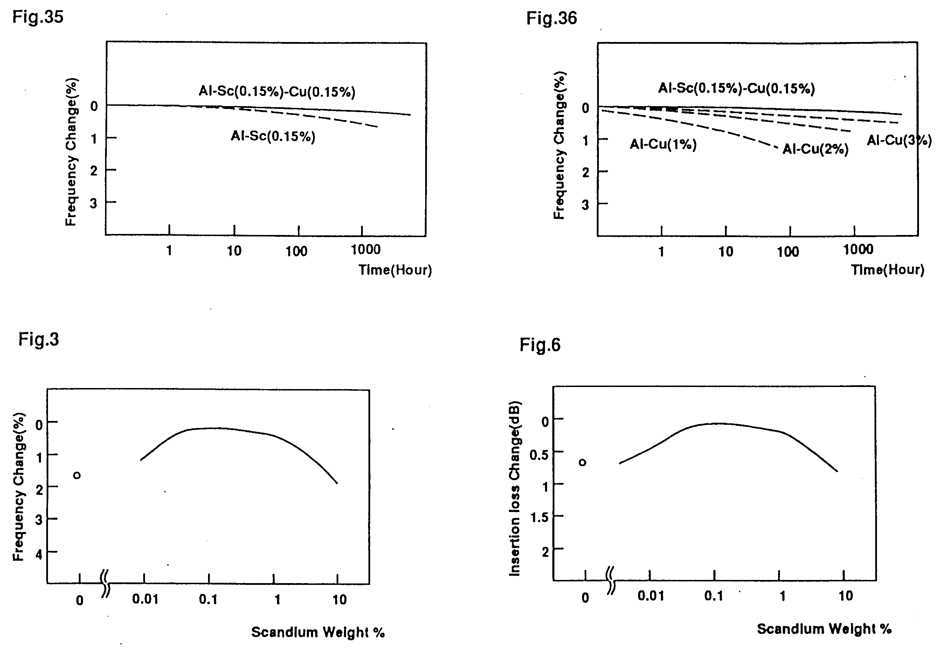

In the same manner as in Example 1 except that 0.15 % by weight of scandium was added to the aluminum metal or 0.15 % by weight of scandium and 0.15 % by weight of copper were added to the aluminum metal to confirm the effect of the addition of copper, a surface acoustic wave resonator having the structure of Fig. 31 was produced. Then, the durability of each surface acoustic wave resonator was evaluated in the same manner as in Example 1. The results are shown in Fig. 35. The effect of the addition of copper was confirmed.

Several surface acoustic wave filters were produced with varying an amount of added each of copper and scandium from 0.01 to 5 % by weight. In this amount range of copper and scandium, the durability of the surface acoustic wave filters was improved. In the above range, the improvement of durability was remarkable in a range between 0.05 % by weight and 0.3 % by weight of scandium.

### Example 22

In the same manner as in Example 1 except that copper alone was added to the aluminum metal or scandium and copper were added to the aluminum metal to confirm the effect of the addition of scandium, a surface acoustic wave resonator was produced. Then, the durability of each surface acoustic wave resonator was evaluated in the same manner as in Example 1. The results are shown in Fig. 36. In order to achieve the same result as achieved by the aluminum metal containing 0.15 % by weight of scandium and 0.15 % by weight of copper, the aluminum metal containing 3 % by weight of copper only should have been used as the electrode metal. When the characteristics of the two surface acoustic wave resonators were compared, the difference due to the electrode resistances was found. That is, the surface acoustic wave resonator using the aluminum metal containing 0.15 % by weight of scandium and 0.15 % by weight of copper had better performances than one using the aluminum metal containing only copper.

With varying the amount of the added scandium, several experiments were carried out. In any case, to achieve the same effect as that achieved by the aluminum metal containing both scandium and copper, a larger amount of copper should have been added to the aluminum metal when copper alone was added. When copper alone was added, the characteristics were degraded due to the increase of electrode resistance.

While in the above Examples, the LiTaO₃ substrate of 36° y-cut and x-propagation was used, it is possible to use a LiTaO₃ substrate of other cut angle or other piezoelectric materials which are conventionally used such as LiNbO₃ can be used in the present invention.

While the above Examples used silicon, palladium, titanium, zinc or copper independently as an additional metal, at least two of them can be simultaneously used.

## Claims

1. A surface acoustic wave device comprising a piezoelectric substrate, a surface acoustic wave transducer which is formed on said piezoelectric substrate and converts an input electric signal to a surface acoustic wave to be propagated on a surface of said piezoelectric substrate, and reflectors consisting of metal strips for reflecting said surface acoustic wave which are formed on said piezoelectric substrate and periodically provided with facing said transducer, wherein at least one of said surface acoustic wave transducer and said reflectors comprises an aluminum metal containing 0.01 to 0.5 % by weight of scandium based on a weight of aluminum.

2. The surface acoustic wave device according to claim 1, wherein a content of scandium is from 0.05 to 0.3 % by weight.

3. The surface acoustic wave device according to claim 1, wherein said aluminum metal further contains 0.01 to 5 % by weight of at least one metal selected from the group consisting of silicon, palladium, titanium, zinc and copper.

4. The surface acoustic wave device according to claim 3, wherein said amount of scandium is from 0.05 to 0.3 % by weight.

5. A surface acoustic wave filter comprising a piezoelectric substrate and at least one pair of surface acoustic wave transducers which are formed on said piezoelectric substrate and covert an input electric signal to a surface acoustic wave to be propagated on a surface of said piezoelectric substrate, wherein said surface acoustic wave transducer comprises an aluminum metal containing 0.01 to 0.5 % by weight of scandium based on a weight of aluminum.

6. The surface acoustic wave filter according to claim 5, wherein a content of scandium is from 0.05 to 0.3 % by weight.

7. The surface acoustic wave device according to claim 5, wherein said aluminum metal further contains 0.01 to 5 % by weight of at least one metal selected from the group consisting of silicon, palladium, titanium, zinc and copper.

8. The surface acoustic wave device according to claim 7, wherein said amount of scandium is from 0.05 to 0.3 % by weight.
